# EUROPEAN PATENT APPLICATION

(11) **EP 1 895 024 A1**
(43) Date of publication of application: **05.03.2008**
(21) Application number: 06756627.3
(22) Date of filing: 26.05.2006
(51) Int. Cl.: C23C 28/00, C23C 22/24, C23C 22/83, C25D 7/00, C25D 11/38, H05K 1/09

(54) **COPPER FOIL FOR PRINTED WIRING BOARD**

(30) Priority: 23.06.2005 JP 2005183100
(71) Applicant: Nippon Mining & Metals Co., Ltd., Minato-ku Tokyo (JP)
(72) Inventor: AKASE, Fumiaki c/o Nippon Mining & Metals Co., Ltd, city, Ibaraki;3170056 (JP)
(74) Representative: Hoarton, Lloyd Douglas Charles
(86) International application number: PCT/JP2006/310527
(87) International publication number: WO 2006/137240

(57) **Abstract**

Provided is a copper foil for a printed circuit board comprising a heatproof treatment layer formed on an non-roughened surface of the copper foil to become a joining surface with resin, a chromate coated layer formed on the heatproof treatment layer, and a silane coupling agent layer formed on the chromate coated layer, wherein the Zn amount of the outermost copper foil surface after forming the silane coupling agent layer is 1.5 Atomic% or less, and the Cr amount is 3.0 to 12.0 Atomic%. This copper foil for a printed circuit board is superior in chemical resistance, adhesiveness, and high frequency characteristics.

## Description

### TECHNICAL FIELD

The present invention relates to a copper foil for a printed circuit board superior in chemical resistance, adhesiveness, and high frequency characteristics. In particular, the present invention relates to a copper foil for a printed circuit board having a brass coated layer formed using electrolytic solution containing copper and zinc ion at least on a joining surface with resin of the copper foil, and which is capable of effectively preventing the erosion (circuit erosion) phenomena of circuit edges arising during etching in the process of forming a printed circuit including the steps of laminating and bonding the copper foil with a brass coated layer on resin, printing a required circuit on the copper foil, and performing etching thereto.

### BACKGROUND ART

A copper foil for a printed circuit is generally laminated and bonded to a base material such as synthetic resin under high temperature and pressure, a required circuit for forming a circuit is thereafter printed, and etching treatment is performed for removing the unwanted parts. Ultimately, required elements are soldered to form various printed circuit boards for electronic devices.

Quality requirements in a copper foil for printed circuit boards are different at the joining surface (so-called roughened surface) to be bonded to the resin base material and at the non-joining surface (so-called glossy surface), and it is important that both are simultaneously satisfied.

Requirements in the glossy surface include (1) having a favorable appearance and no oxidization and discoloration during storage, (2) having favorable solder wettability, (3) no oxidization and discoloration during high-temperature heating, and (4) having favorable adhesiveness with a resist.

Meanwhile, primary requirements in the roughened surface include (1) no discoloration during storage, (2) having sufficient peel strength with the base material even after high-temperature heating, wet treatment, soldering, chemical treatment and the like, and (3) no so-called lamination stain arising after lamination with the base material and etching.

Further, a low profile of the copper foil is demanded pursuant to the finer patterns used in recent years.

In addition, with electronic equipment such as personal computers and mobile communication terminals, higher frequency of electric signals is progressing pursuant to high speed communication and high capacity of such electronic equipment, and printed circuit boards and copper foils capable of accommodating such demands are being sought. When the frequency of an electric signal becomes 1 GHz or greater, influence of the skin effect where the current only flows on the surface of the conductor becomes significant, and the influence caused by the change of current transmission path due to irregularities on the surface and increase of impedance can no longer be ignored. From this perspective also, it is desirable that the surface roughness of the copper foil is small.

Various methods of treatment of copper foils for printed circuit boards have been proposed in order to meet the foregoing needs.

Although the treatment method will differ with a rolled copper foil and an electrolytic copper foil, an example of a treatment method of an electrolytic copper foil is described below.

In other words, foremost, in order to increase the bond strength (peel strength) of copper and resin, particles of copper and copper oxide are adhered to the copper foil surface (etching treatment), and a heatproof treatment layer (barrier layer) of brass or zinc is thereafter formed to provide heat resistance properties.

Finally, in order to prevent the surface oxidation during transport or storage, rustproof treatment such as immersion or electrolytic chromate treatment, or electrolytic chrome/zinc treatment is performed to the product.

Among the above, in particular, the treatment method of forming the heatproof treatment layer is crucial in determining the surface property of the copper foil. Thus, as examples of metals or alloys used in forming the heatproof treatment layer, numerous copper foils formed with a coated layer of Zn, Cu-Ni, Cu-Co, Cu-Zn and so on have been put into practical use (for instance, refer to Patent Document 1).

Among the above, a copper foil formed with a heatproof treatment layer formed from Cu-Zn (brass) is widely used commercially since it has superior characteristics such as no stains on the resin layer when laminated on a printed circuit board formed from epoxy resin, and hardly any deterioration in the peel strength after high-temperature heating.

Patent Document 2 and Patent Document 3 describe in detail the method of forming this heatproof treatment layer formed from brass.

The copper foil formed with this heatproof treatment layer formed from brass is subsequently subject to etching treatment for forming a printed circuit. In recent years, a hydrochloric acid etching solution is often used in forming the printed circuit board.

Nevertheless, when performing etching treatment with a hydrochloric acid etching solution (for instance, CuCl₂, FeCl₃) to the printed circuit board employing the copper foil formed with this heatproof treatment layer formed from brass, there is a problem in that a so-called erosion (circuit erosion) phenomena of circuit edges will occur on both sides of the circuit pattern, and the peel strength with the resin base material will deteriorate.

A circuit erosion phenomena is a phenomena where the hydrochloric acid etching solution erodes the lateral etching surface of the bonding boundary layer of the copper foil and the resin base material; that is, the heatproof treatment layer formed from brass, of the circuit formed with the foregoing etching treatment, both sides that are ordinarily yellow (due to brass) are eroded and become red due to lack of subsequent water washing, and the peel strength of such portion deteriorates considerably. If this phenomenon occurs to the overall circuit pattern, there is a major problem in that the circuit pattern will peel off from the base material.

As a reason for this circuit erosion phenomena occurring, it is considered that, when using a hydrochloric acid etching solution, curprous chloride (CuCl) having low solubility is generated during the reaction process, and, when this is deposited on the base material surface, it reacts with zinc in the brass, and is eluted as zinc chloride (so-called dezincification of brass). The presumed reaction formula is as follows. 2 CuCl + Zn (zinc in brass) → ZnCl₂ + 2Cu° (copper in brass subject to dezincification) Thus, a proposal has been made for improving the resistance to hydrochloric acid corrosion by performing roughening treatment to the copper foil surface, and performing rustproof treatment and chromate treatment to zinc or zinc alloy, and thereafter adsorbing a silane coupling agent containing a small amount of chrome ion to the surface subject to chromate treatment (refer to Patent Document 3).

Nevertheless, in the foregoing case, although chrome ion is effective in improving the resistance to hydrochloric acid corrosion, the silane coupling agent adsorbed to the copper foil surface is a material that is weak against heat and deteriorates easily. Thus, there is a problem in that, together with the deterioration of the silane coupling, the chrome ion contained in the silane coupling agent will follow and lose its effect. In other words, there is a significant problem in that this copper foil lacks stability.

Based on recent demands of finer patterns and higher frequencies, the present inventors have proposed a copper foil in which the roughness of the copper foil is reduced with non-roughening or low-roughening treatment (refer to Patent Document 4). Here, by performing appropriate surface treatment to the non-roughened or low-roughened foil, it was possible to improve the adhesiveness with an insulating resin compatible with high frequencies. Nevertheless, the problem of acid resistance became significant with a foil that is subject to non-roughening treatment and showed a 100% loss, and acid resistance was still insufficient after performing the silicon pretreatment proposed in Patent Document 4, and the improvement thereof was desired.
[Patent Document 1] Published Examined Patent Application No. S51-35711
[Patent Document 2] Published Examined Patent Application No. S54-6701
[Patent Document 3] Japanese Patent No. 3306404
[Patent Document 4] Japanese Patent Application No. 2002-170827

### SUMMARY OF THE INVENTION

An object of the present invention is to develop a copper foil for a printed circuit board comprising a heatproof treatment layer formed from brass capable of avoiding the circuit erosion phenomena without deteriorating the various other characteristics.

In particular, an object of the present invention is to establish electrolytic treatment technology of a copper foil capable of completely preventing the circuit erosion phenomena even when using a hydrochloric acid etching solution without deteriorating characteristics such as hardly causing any stain on a resin layer when laminated on a resin base material and minimal deterioration in the peel strength after high-temperature heating.

In order to achieve the foregoing object, as a result of intense study concerning the conditions for forming a heatproof treatment layer from brass, the present inventors discovered that the following copper foil for a printed circuit board is effective in resistance to hydrochloric acid corrosion.
1) A copper foil for a printed circuit board comprising a heatproof treatment layer formed on an non-roughened surface of the copper foil to become a joining surface with resin, a chromate coated layer formed on the heatproof treatment layer, and a silane coupling agent layer formed on the chromate coated layer, wherein the Zn amount of the outermost copper foil surface after forming the silane coupling agent layer is 1.5 Atomic% or less, and the Cr amount is 3.0 to 12.0 Atomic%;
2) The copper foil for a printed circuit board according to 1) above, wherein the copper foil is an electrolytic copper foil or a rolled copper foil;
3) The copper foil for a printed circuit board according to 1) or 2) above, wherein the heatproof treatment layer is a brass coated layer; and
4) The copper foil for a printed circuit board according to any one of 1) to 3) above, wherein the chromate coated layer is an electrolytic chromate coated layer or an immersion chromate coated layer.

### [Effect of the Invention]

As described above, the copper foil for a printed circuit board of the present invention yields new characteristics in that it will be possible to completely prevent the circuit erosion phenomena even when using a hydrochloric acid etching solution without deteriorating characteristics of conventional heatproof coated layers formed from brass such as hardly causing any stain on the resin layer and minimal deterioration in peel strength after high-temperature heating. The present invention is extremely effective as a copper foil for a printed circuit where finer patterns and higher frequencies of printed circuits are progressing in recent years.

### BEST MODE FOR CARRYING OUT THE INVENTION

The present invention is now explained specifically and in detail in order to facilitate the understanding of this invention. The copper foil used in the present invention may be an electrolytic copper foil or a rolled copper foil.

Ordinarily, for the purpose of improving the peel strength of the copper foil after being laminated at least on one surface of the copper foil, roughening treatment of conducting electrodeposition of knobby copper is performed on the copper foil surface after degreasing. The present invention, however, is applicable to a non-roughened copper foil that is not subject to this kind of roughening treatment.

Foremost, brass plating as the brass coated layer is performed on at least one surface of the copper foil. Needless to say, this may be performed to both surfaces. Particularly, in order to completely prevent the circuit erosion phenomena without reducing the characteristics such as hardly causing stain on the resin layer when the copper foil is laminated on a resin base material and minimal deterioration in the peel strength after high-temperature heating, it is desirable to form a brass-coated layer having a zinc content of 15 to 30wt% with an electrical quantity of 30 to 60A•s/dm². Nevertheless, what is vital in the present invention is that the Zn amount of the outermost copper foil surface after forming the silane coupling agent layer is 1.5 Atomic% or less, and the Cr amount is 3.0 to 12.0 Atomic%. So as long as these conditions are satisfied, the present invention can be applied to a brass coated layer outside the scope of the foregoing numerical values as a matter of course, and these are also covered by the present invention.

Meanwhile, if the zinc content is less than 30%, in consideration of costs, it is preferable that the electrical quantity is 60A•s/dm² or less, more preferably 50A•s/dm² or less, and most preferably around 40A•s/dm². Electrical quantity (A•s/dm²) is the product of current density (A/dm²) and plating time in seconds (s), and it is necessary to select an appropriate plating time according to the current density in order to obtain a prescribed electrical quantity. Nevertheless, since an optimal value of current density will be selected based on the manufacturing equipment and conditions of copper foil such as the liquid flow rate of the plating bath and plating solution composition, it is not possible to set the value uniquely, but is normally 1 to 10A/dm², and preferably 4 to 8A/dm². Plating time is selected so as to obtain a required electrical quantity from the optimal value in the foregoing range.

Further, since the zinc content can be changed by adjusting the ratio of copper and zinc in the plating solution, it is possible to suitably select the target zinc content. The following is a summarization of the brass plating electrolytic solution and electrolytic conditions in a cyan electrolytic solution.

### B. (Brass (Cu-Zn) plating conditions)

NaCN: 10 to 30g/L, NaOH: 40 to 100g/L, CuCN: 60 to 120g/L (copper ion 42.5 to 85g/L), Zn(CN)₂: 1 to 10g/L (zinc ion 0.6 to 5.6g/L) pH: 10 to 13, temperature: 60 to 80°C, current density: 1 to 10A/dm², time: 1 to 10 seconds

Thereafter, in order to prevent the oxidization of the copper foil formed with the foregoing coated layer, a rustproof layer is formed on at least one surface of the copper foil. Although a publicly known rustproof layer forming method may be applied to the present invention, it is preferable to form a rustproof layer formed from chrome oxide based on immersion chromate treatment or electrolytic chromate treatment, or a compound of chrome oxide and zinc or zinc oxide based on electrolytic chrome/zinc treatment.

This rustproof treatment has a significant influence on the resistance to hydrochloric acid corrosion. In other words, the reason why a chrome oxide layer is formed on the brass surface of the copper foil due to chromate treatment is based on the substitution reaction with zinc in the brass. Therefore, it is necessary that zinc exists in the copper foil surface before the chromate treatment.

Meanwhile, the chromate treatment layer is not necessary a uniform surface, and surface irregularities can be observed microscopically. Such surface irregularities signify that zinc may appear on the front face of the chromate treatment. In addition, zinc may also diffuse this kind of chromate coated layer.

In the foregoing case, the exposed zinc may cause the deterioration in the resistance to hydrochloric acid corrosion. Therefore, although the base brass layer surface requires the existence of zinc to a certain degree, it is necessary to reduce the Zn amount of the outermost copper foil surface after forming the silane coupling agent layer, and it has been discovered that such amount should be 1.5 Atomic% or less. Meanwhile, it is important that the Cr amount is 3.0 to 12.0 Atomic% from the perspective of acid resistance.

Like this, by adjusting the Zn amount and Cr amount of the outermost copper foil surface, it is possible to exponentially improve the resistance to hydrochloric acid corrosion. Incidentally, if the Cr amount exceeds 12.0 Atomic%, the etching property will deteriorate, and etching remnants may arise. Thus, it is desirable to set the upper limit thereof to be 12.0 Atomic%.

When forming a chromate treatment layer, it is also possible to perform electrolytic chrome/zinc treatment. Nevertheless, it is still necessary to adjust the Zn amount and Cr amount of the outermost copper foil surface to be within the foregoing range in this case as well.

An example of the electrolytic conditions for forming the foregoing rustproof layer is described below by way of reference.
(a) Immersion chromate treatment
   K₂Cr₂O₇: 1 to 5g/L, pH: 2.5 to 4.5, temperature: 40 to 60°C, time: 0.5 to 8 seconds
(b) Electrolytic chromate treatment (chrome/zinc treatment (alkaline bath)) K₂Cr₂O₇: 0.2 to 20g/L, acid : phosphoric acid, sulfuric acid, organic acid, pH: 1.0 to 3.5, temperature: 20 to 40°C, current density: 0.1 to 5A/dm², time: 0.5 to 8 seconds
(c) Electrolytic chrome/zinc treatment (alkaline bath)
   K₂Cr₂O₇ (Na₂Cr₂O₇ or CrO₃): 2 to 10g/L, NaOH or KOH: 10 to 50g/L, ZnOH or ZnSO₄•7H₂O: 0.05 to 10g/L, pH: 7 to 13, bath temperature: 20 to 80°C, current density: 0.05 to 5A/dm², time: 5 to 30 seconds
(d) Electrolytic chromate treatment (chrome/zinc treatment (acidic solution))
   K₂Cr₂O₇: 2 to 10g/L, Zn: 0 to 0.5g/L, Na₂SO₄: 5 to 20g/L, pH: 3.5 to 5.0, bath temperature: 20 to 40°C, current density: 0.1 to 3.0A/dm², time: 1 to 30 seconds

### [Examples]

Examples of the present invention are now explained. These Examples merely illustrate a preferred example, and the present invention shall in no way be limited thereby. In other words, all modifications, other embodiments and modes covered by the technical spirit of the present invention shall be included in this invention.

Incidentally, the Comparative Examples are indicated in the latter part for comparison with the present invention.

### (Examples 1 to 7)

A prearranged electrolytic copper foil having a thickness of 35*µ*m was used to foremost form a heatproof coated layer formed from brass on a glossy surface (S surface) of the copper foil with the electrolytic solution and under the electrolytic conditions described below.

Further, the following immersion chromate treatment and electrolytic chromate treatment were performed to both surfaces of the copper foil formed with the heatproof coated layer so as to form a rustproof layer. Silane treatment (by application) was performed on this rustproof layer.

Incidentally, the foregoing electrolytic solution and electrolytic conditions were all performed under the same conditions. The treatment conditions are shown below.
(a) Brass (Cu-Zn) plating
   NaCN: 10 to 30g/L, NaOH: 40 to 100g/L, CuCN: 60 to 120g/L, Zn(CN)₂: 1 to 10g/L, pH: 10 to 13, temperature: 60 to 80°C, current density: 1 to 10A/dm², time: 1 to 10 seconds
(b) Immersion chromate treatment
   K₂Cr₂O₇: 1 to 5g/L, pH: 2.5 to 4.5, temperature: 40 to 60°C, time: 0.5 to 8 seconds
(c) Electrolytic chromate treatment (chrome/zinc treatment (acidic solution))
   K₂Cr₂O₇: 2 to 10g/L, Zn: 0 to 0.5g/L, Na₂SO₄: 5 to 20g/L, pH: 3.5 to 5.0, bath temperature: 20 to 40°C, current density: 0.1 to 3.0A/dm², time: 1 to 30 seconds

The copper foil prepared as described above was laminated and bonded on a glass cloth base material epoxy resin substrate, and the following items were measured or analyzed.
(1) Peel strength test
   The peel strength of copper foil after heat treatment at a normal condition (room temperature) and 180°C x 48 hours with a circuit having a width of 10mm.
(2) Lamination stain observation test
   The copper foil was etched with a hydrochloric acid etching solution, and stain or contamination on the copper foil etched surface after heat treatment of 180°C x 1 hour was observed.
(3) Zn amount and Cr amount analysis
   ESCA analysis of the Zn amount and Cr amount of the outermost copper foil surface after forming the silane coupling agent layer.
(4) Test result of acid resistance (18% hydrochloric acid: room temperature)
   The test was conducted with a 1 mm circuit.

Table 1 shows ESCA surface analysis of the Zn amount and Cr amount of the outermost copper foil surface after forming the silane coupling agent layer, test result of acid resistance (18% hydrochloric acid: room temperature), chromate plating conditions, current density, and coulomb.

**[Table 1]**

| No | ESCA Surface Analysis (Atomic%) | | Acid Resistance | Normal Peel | Peel after Heat Treatment | Chromate Treatment | Current Density | Coulomb |
|---|---|---|---|---|---|---|---|---|
| | Zn | Cr | (%Loss) | (kg/cm) | (kg/cm) | | (A/dm2) | (As/dm2) |
| Example 1 | 0.1 | 5.2 | 0.0 | 0.84 | 0.80 | Dip-Cr | 0 | 0 |
| Example 2 | 0.5 | 3.6 | 0.0 | 0.80 | 0.75 | Electrolytic Cr | 0.1 | 0.3 |
| Example 3 | 0.5 | 3.0 | 7.1 | 0.80 | 0.76 | Electrolytic Cr | 0.2 | 0.3 |
| Example 4 | 0.7 | 6.4 | 8.3 | 0.81 | 0.77 | Electrolytic Cr | 0.2 | 0.6 |
| Example 5 | 1.4 | 9.8 | 8.1 | 0.88 | 0.82 | Electrolytic Cr | 0.2 | 1 |
| Example 6 | 1.5 | 11.9 | 7.4 | 0.90 | 0.85 | Electrolytic Cr | 0.2 | 1.5 |
| Example 7 | 1.0 | 3.7 | 9.1 | 1.08 | 1.00 | Electrolytic Cr | 0.3 | 0.33 |
| Comparative Example 1 | 3.0 | 5.8 | 100 | 0.83 | 0.77 | Electrolytic Cr | 0.7 | 1.7 |
| Comparative Example 2 | 2.4 | 5.4 | 20.5 | 0.81 | 0.76 | Electrolytic Cr | 0.7 | 1 |
| Comparative Example 3 | 0.2 | 0.0 | 100 | 0.80 | 0.74 | None | 0 | 0 |
| Comparative Example 4 | 0.3 | 2.6 | 15.6 | 0.80 | 0.73 | Electrolytic Cr | 0.1 | 0.2 |

As shown in Table 1, Examples 1 to 7 have acid resistance of less than 10% loss, and Comparative Examples 1 to 4 considerably exceed 10% loss, and it has been confirmed that the present invention yields effects in improving acid resistance. Accordingly, it is evident that the present invention is able to significantly improve the circuit erosion phenomena without deteriorating characteristics of conventional heatproof coated layers formed from brass such as hardly causing any stain on the resin layer and minimal deterioration in peel strength after high-temperature heating.

### INDUSTRIAL APPLICABILITY

As described above, it has been discovered that the circuit erosion phenomena could be effectively prevented by forming a heatproof treatment layer on an non-roughened surface of the copper foil to become a joining surface with resin, forming a chromate coated layer on the heatproof treatment layer, and forming a silane coupling agent layer on the chromate coated layer, and making the Zn amount of the outermost copper foil surface after forming the silane coupling agent layer to be 1.5 Atomic% or less, and making the Cr amount to be 3.0 to 12.0 Atomic%.

When the surface treated copper foil formed as described above is laminated on a resin base material, new characteristics in that it will be possible to completely prevent the circuit erosion phenomena even when using a hydrochloric acid etching solution without deteriorating characteristics of conventional heatproof coated layers formed from brass such as hardly causing any stain on the resin layer and minimal deterioration in peel strength after high-temperature heating. The present invention is extremely effective as a copper foil for a printed circuit where finer patterns and higher frequencies of printed circuits are progressing in recent years.

## Claims

1. A copper foil for a printed circuit board comprising a heatproof treatment layer formed on an non-roughened surface of the copper foil to become a joining surface with resin, a chromate coated layer formed on the heatproof treatment layer, and a silane coupling agent layer formed on the chromate coated layer, wherein the Zn amount of the outermost copper foil surface after forming the silane coupling agent layer is 1.5 Atomic% or less, and the Cr amount is 3.0 to 12.0 Atomic%.

2. The copper foil for a printed circuit board according to claim 1, wherein the copper foil is an electrolytic copper foil or a rolled copper foil.

3. The copper foil for a printed circuit board according to claim 1 or claim 2, wherein the heatproof treatment layer is a brass coated layer.

4. The copper foil for a printed circuit board according to any one of claims 1 to 3, wherein the chromate coated layer is an electrolytic chromate coated layer or an immersion chromate coated layer.
